# EUROPEAN PATENT APPLICATION

(11) **EP 0 696 057 A1**
(43) Date of publication of application: **07.02.1996**
(21) Application number: 94907059.3
(22) Date of filing: 16.02.1994
(51) Int. Cl.: H01L 21/68

(54) **CONTAINER FOR PACKING SEMICONDUCTOR WAFER**

(30) Priority: 27.04.1993 JP 136392/93; 28.07.1993 JP 227755/93
(71) Applicant: KOMATSU ELECTRONIC METALS CO., LTD, Hiratsuka-shi Kangawa 254 (JP); KOMATSU PLASTICS INDUSTRIAL CO., LTD., Tokyo 107 (JP)
(72) Inventor: YAMADA, Naoki, Kyushu Komatsu Electronics, Miyazaki-gun, Miyazaki 889-16 (JP); TERADA, Mitsuo, Kyushu Komatsu Electronics, Miyazaki-gun, Miyazaki 889-16 (JP); NISHIZAWA, Kiyoshi, Hirakata-shi, Osaka 573 (JP); UCHIDA, Jun, Kokubunji-shi, Tokyo 185 (JP)
(74) Representative: Stachow, E.-W., Prof. Dr.
(86) International application number: PCT/JP94/00236
(87) International publication number: WO 94/25980

(57) **Abstract**

A container for packing semiconductor wafer which is having excellent airtightness and which can improve the prevention from contamination by the air.

A gasket groove formed on a case of a container for packing semiconductor wafer, and then a gasket is inserted therein. A case and a lid are fasten by the engagements between four clips and four clip recesses.

## Description

### Technical Field

This invention is relating to the container for packing semiconductor wafers which is available to be in the safekeeping and to transport safely by preventing from damages or contamination of the wafers.

### Background of the Invention

Prior arts of the container for packing semiconductor wafer are disclosed in JP. A. 3-114245 and the others. They are generally consist of a wafer carrier which contains plural wafers therein, a case which holds the wafer carrier therein, a lid and a wafer pressing part.

A wafer carrier has plural holding grooves which the lower portions are inwardly curved in order to contain plural wafers therein. A case has a protruding line or a groove along the top of the brim in order to shut the lid tightly thereon. Two latches are deposited at sides of the brim against one another and are engaged with recesses of the lid in order to fasten the lid.

However, the airtightness by the above described structure is not enough to prevent from contamination by the air. Because the lid can neither cling to the brim of the case perfectly nor can be fastened firmly by only two latches.

Accordingly, it is an object of the present invention to provide a container for packing semiconductor wafer which is having excellent airtightness and which can improve the prevention from contamination by the air.

### Disclosure of the Invention

To accomplish the foregoing objects,
a container for packing semiconductor wafers of the present invention comprising;
a wafer carrier having plural holding grooves on the opposing inner walls to contain the wafers individually therein,
a wafer support which is deposited above said wafer carrier to press and hold the wafers,
a case which is box-shaped and having an open top to contain said wafer carrier and said wafer support, and
a lid which is fitted on said case to form an airtight container;
characterized in that
said wafer support includes a base plate and plural supporting spring rows which is pectinately protruding against each wafers at both edges of the base plate, and is fixed on said lid removably;
said case includes four sidewalls, a sash having plane surfaces and perpendicular corners, said sash is united with said sidewalls, handles, dented potions formed under said handles, a seal groove formed on the top of said sash for a insertion of a gasket, clip recesses respectively formed at the middle of said plane surfaces for engaging with clips, a bottom plate provided at bottom ends of said four sidewalls, an arrow drawn on said bottom plate, and dents which are inwardly depressed at the bottom plate for the pile of the containers;
said lid includes four sidewalls, eaves united and horizontally protruding from said sidewalls, a sash having plane surfaces and perpendicular corner, clip recesses respectively formed at middle of said plane surfaces for engaging with clips, engaging holes to engage with top end protrusions of the clips, clips removably engaging with the lid, a ceiling provided on the top end of the sidewalls, protruding corners formed on said ceiling for the pile of the containers, and engaging grooves provided inner surface of said ceiling to removably engage with the base plate of said wafer support;
whereby semiconductor wafers are contained in said wafer carrier and held between each parts of said case and said lid.

### Brief description of the Drawings

Figure 1 is an exploded perspective view of a container for packing semiconductor wafer of the present invention,
Figure 2 is an elevation partly in section of a container with a wafer carrier which is containing wafers,
Figure 3 is a left side view of Figure 2,
Figure 4 is an elevation partly in section of a case,
Figure 5 is a left side view of Figure 4,
Figure 6 is a top plan view of a case,
Figure 7 is an elevation partly in section of a lid,
Figure 8 is a top plan view of a lid,
Figure 9 is an elevation of clip,
Figure 10 is ah A-A sectional view of Figure 9,
Figure 11 is a top plan view of a wafer support,
Figure 12 is a right side view of Figure 11,
Figure 13 is an elevation of a wafer support,
Figure 14 is an elevation partly in section of a wafer carrier,
Figure 15 is a right side view of Figure 14,
Figure 16 is a top plan view of a wafer carrier,
Figure 17 is a bottom view of a wafer carrier,
Figure 18 is a top plan view of a gasket, and
Figure 19 is an enlarged A-A sectional view of Figure 18.

### Best mode of Carrying out the Invention

An embodiment of the present invention is described by referring the drawings.

The container 10 of the present invention is used for safekeeping and transporting of semiconductor wafers which are held in a wafer carrier 13.

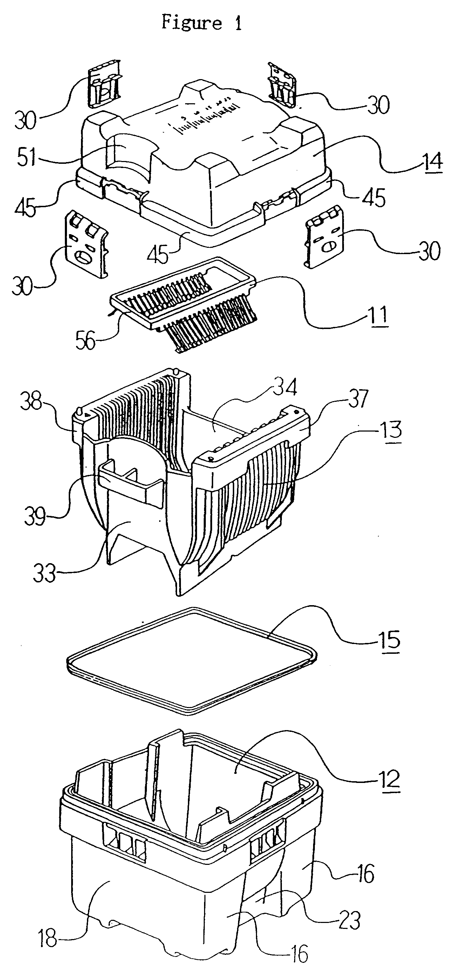

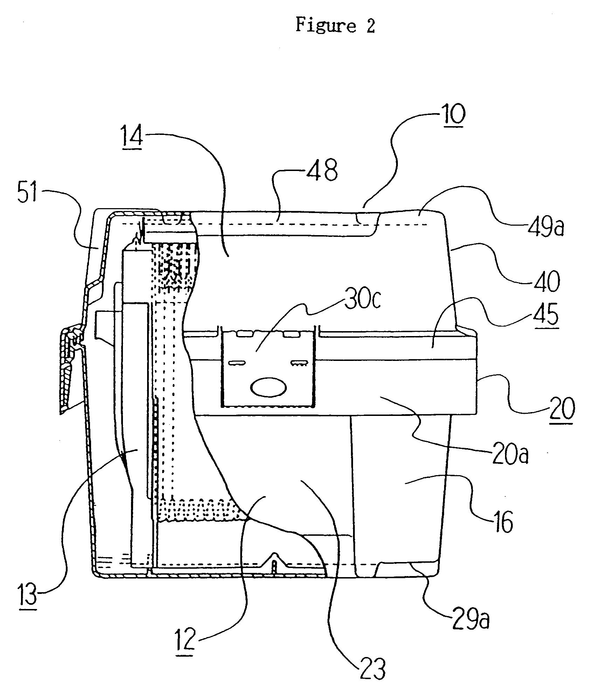

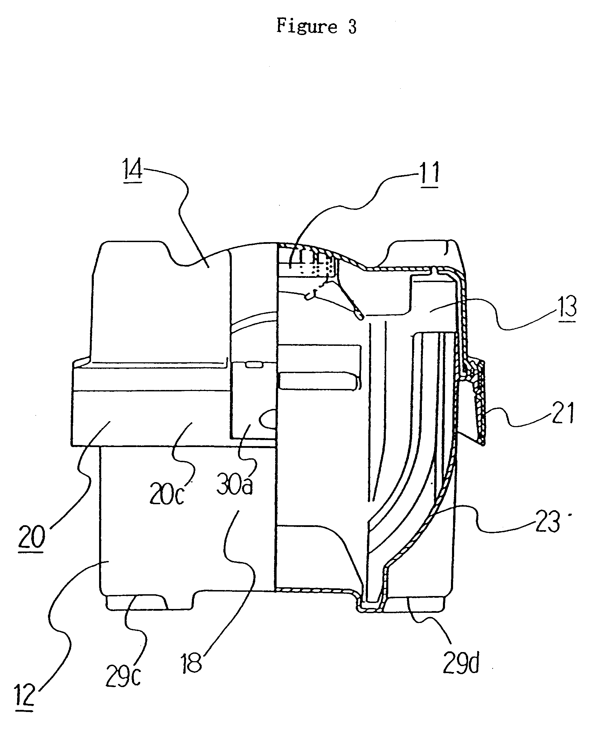

As showing in Figure 1, a container 10 comprises a case 12 and a lid 14, and the lid 14 covers the open top of the case 10. As showing in Figure 2 and Figure 3, a case 12 contains a wafer carrier 13 therein.

The case 12 includes sidewalls 16, 17, 18, 19, a sash 20, handles 21, 22 and a dented portion 23, 24. The sash 20 comprises plane surfaces 20a, 20b, 20c and 20d. Both side ends of each plane surfaces are jointed each other and respectively form round perpendicular corners. The plane surfaces 20a, 20b, 20c and 20d are respectively united with the sidewalls 16, 17, 18 and 19. The sidewall 16 has a dented portion 23 under the handle 21, and the sidewall 17 which is opposing to sidewall 16 has a dented portion 24 under the handle 22.

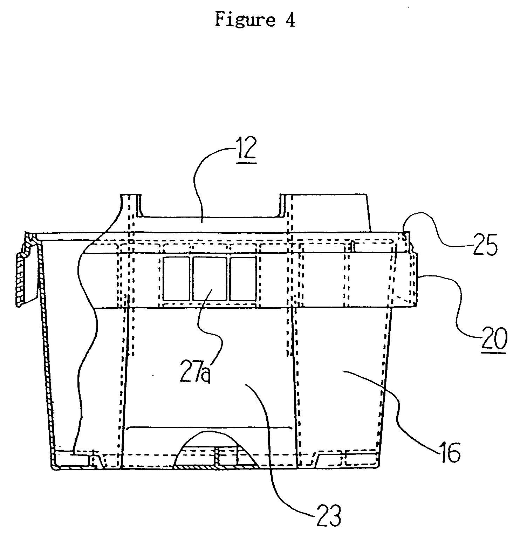

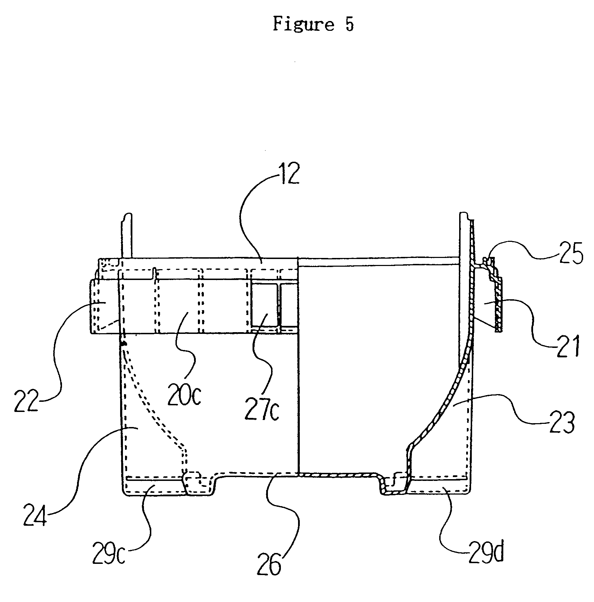

As showing in Figure 4 and Figure 5, a seal groove 25, which is U-shaped, is formed on the top ends of the plane surfaces 20a, 20b, 20c and 20d. A gasket 15 is put into the seal groove 25.

As showing in Figure 4 and Figure 5, clip recesses 27a, 27b, 27c and 27d are formed to engage with four clips 30 of the lid 14 at the middle of the each plane surfaces 20a, 20b, 20c and 20d.

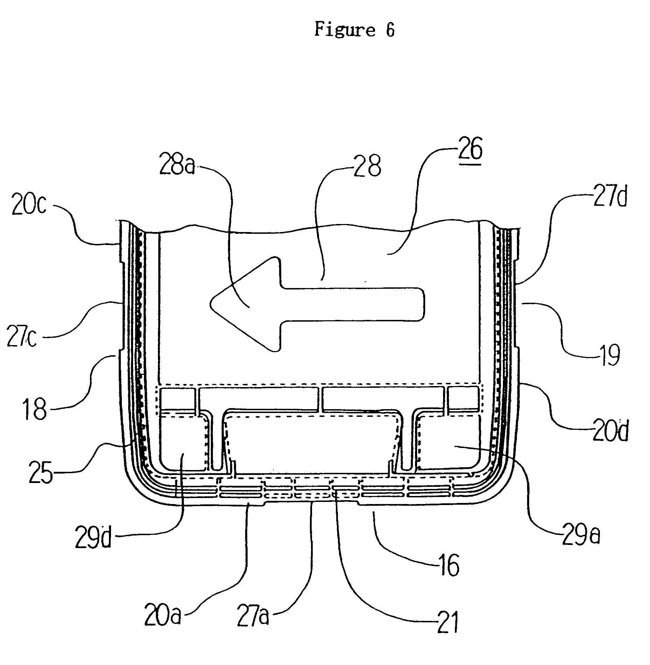

As showing in Figure 6, a bottom plate 26 of the case 12 is united with each bottom ends of the sidewalls 16, 17, 18 and 19, and an arrow 28a is drawn on the center 28 of the bottom plate 26. The arrow 28a is showing the direction of a mirror side of a wafer and the direction for an insertion of the wafer carrier 13. The bottom plate 26 has square dents 29a, 29b, 29c and 29d depressed toward the inside of the case 12 on the each corners thereof.

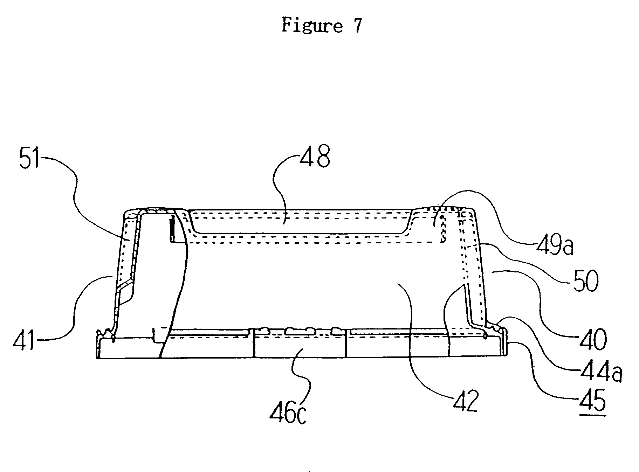

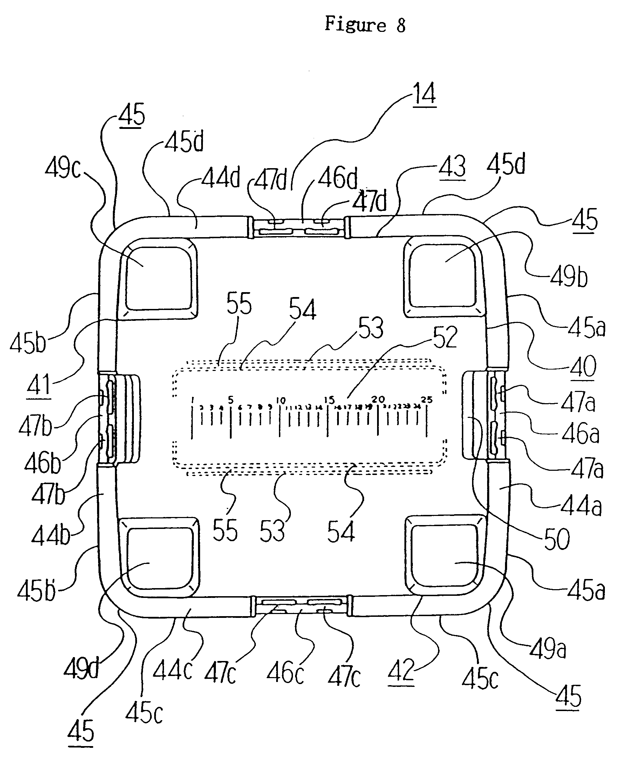

As showing in Figure 7 and Figure 8, the lid 14 includes sidewalls 40, 41, 42, 43, eaves 44a, 44b, 44c, 44d, and a sash 45. The eaves 44a, 44b, 44c and 44d are horizontally protruding from the bottom end of sidewalls 40, 41, 42 and 43 in order to engage with the seal groove 25. The eaves 44a, 44b, 44c and 44d are having a sash 45, which is comprising plane surfaces 45a, 45b, 45c and 45d, underneath thereof. Each corners of the sash 45 are round perpendicular. The sash 45 of lid 14 is corresponded with the sash 20 of the case 12 as forming one surface, when the lid 14 covers the case 12.

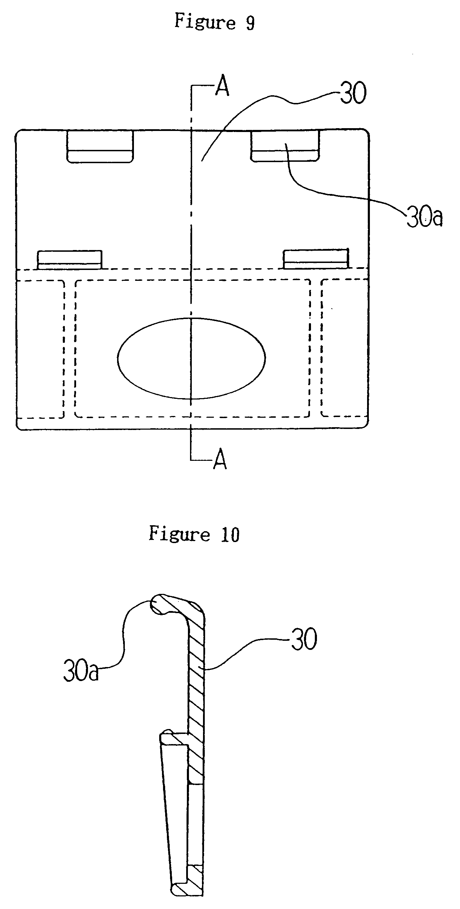

As showing Figure 1, Figure 3, Figure 7, Figure 8, Figure 9 and Figure 10, clip recesses 46a, 46b, 46c and 46d are formed respectively at the middle of the plane surfaces 45a, 45b, 45c and 45d in order to engage with four clips 30. Each clip recesses have engaging hole 47a, 47b, 47c and 47d in order to engage with top end protrusions 30a of the clips 30. The clips 30 are removably engaged on the lid 14.

As showing Figure 3, Figure 7 and Figure 8, the lid 14 further includes a ceiling 48 which is having curved center 48, and protruding corners 49a, 49b, 49c and 49d which are upwardly protruding. The protruding corners 49a, 49b, 49c and 49d are relatively designed to put the dents 29a, 29b, 29c and 29d of another case 12 thereon. Whereby plural containers 10 can be piled up.

The sidewall 40 and 41 respectively have reinforcing dents 50 and 51 in order to firmly keep the shape of the lid 14 and to identify front and rear of the lid 14.

The lid 14 is formed by a plastic ejection of the transparent resin, e.g. polycarbonate or etc., whereby articles in the container 10 are able to be seen easily. A scale 52 with figures is depicted on the upper side of the ceiling 48 in order to make sure the number and the positions of wafers of the inside.

The lid 14 has an engaging groove 55, which is formed by protruding lines 53 and 54, at the inner side of the ceiling 48. The engaging groove 55 is shaped approximately rectangular corresponding to a base plate 56 of the wafer support 11, whereby the wafer support 11 is removably installed therein.

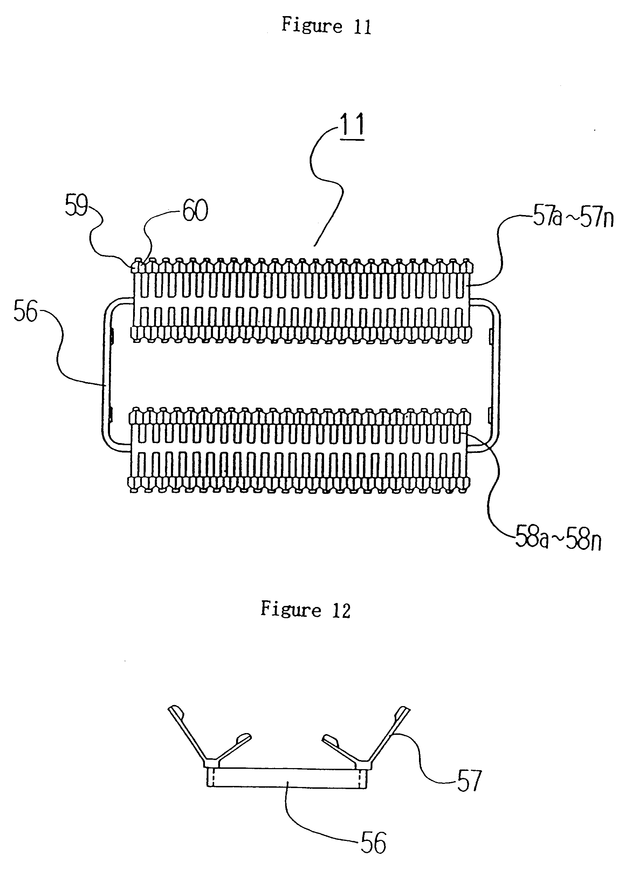

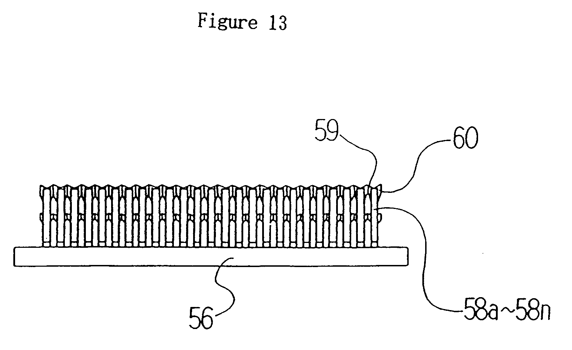

As showing in Figure 11, Figure 12 and Figure 13, the wafer support 11 has plural supporting spring rows 57a∼57x and 58a∼58x which are pectinately and individually protruding from both elongated side of the base plate 56. Each supporting spring rows have resiliency. The number of the supporting spring rows are depend on the number of the wafers which can be contained in the container. The supporting spring rows 57a∼57x and 58a∼58x are united each other and downward open at the almost perpendicular angles. The supporting spring rows 57a∼57x and 58a∼58x respectively have spring teeth 59 and 60 at the end thereof. The spring teeth 59 and 60 are molded so as to open downward in approximately 90° .The spring teeth respectively contact with the edge of the wafers

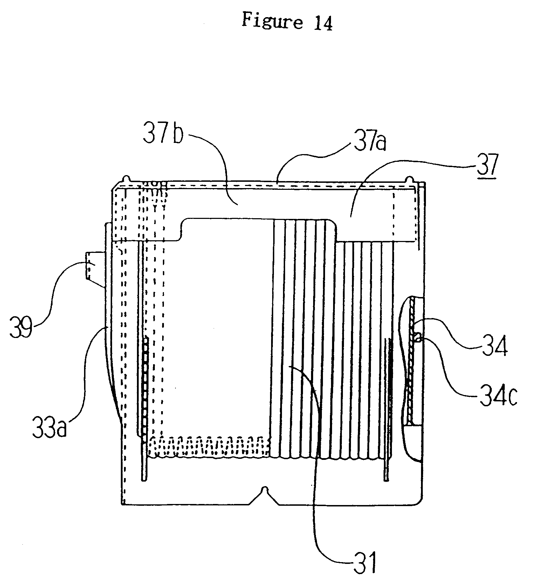

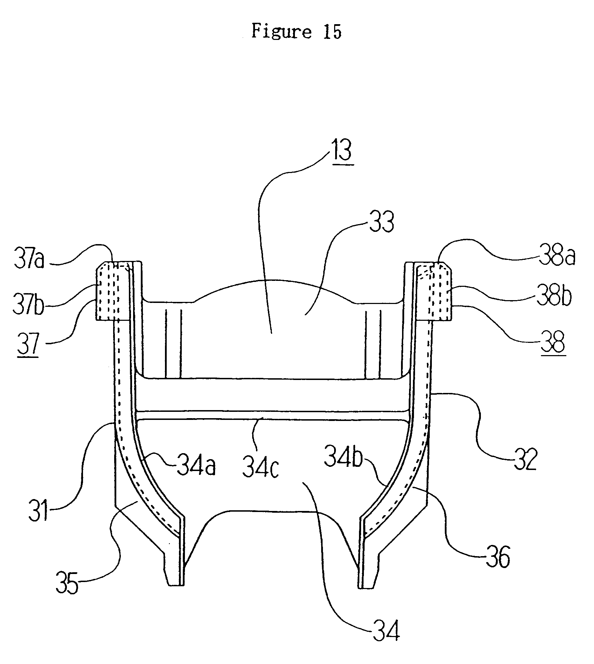

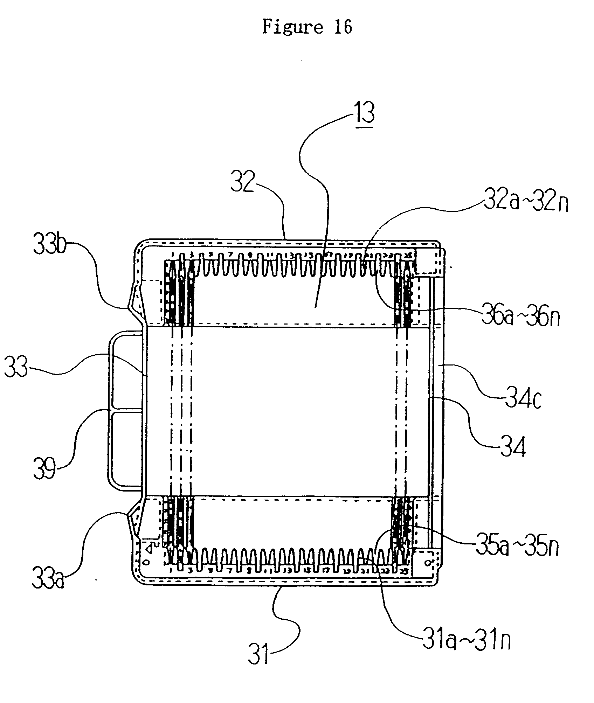

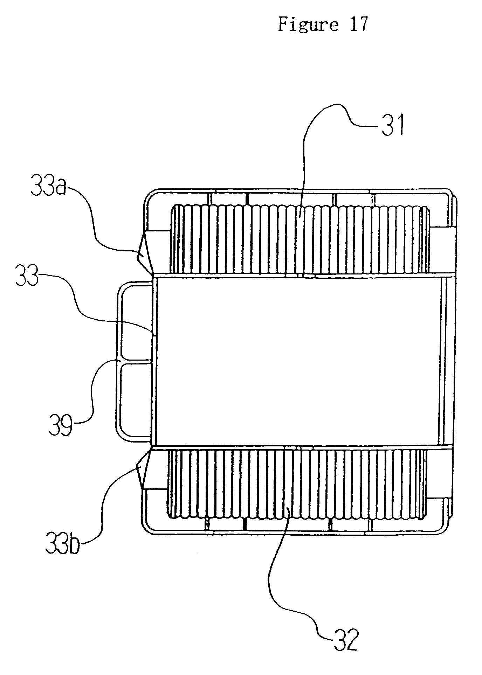

As showing in Figure 14, Figure 15, Figure 16 and Figure 17, a wafer carrier 13 comprises side plates 31, 32, a front plate 33 and a rear plate 34 which are molded as an unite. The bottom of the wafer carrier 13 is opening. The side plates 31 and 32 are symmetrical and upright, and their lower portions are inwardly curved to be able to hold semiconductor wafers therein. The inner surfaces of the side plate 31 and 32 respectively have opposing series of spacing ribs 31a∼31x and spacing ribs 32a∼32x. Holding grooves 35a∼35x and 36a∼36x are formed between each spacing ribs 31a∼31x and 32a∼32x, and semiconductor wafers are, then, respectively inserted into the holding grooves for spacing axially and preventing from contacts by each other.

The spacing ribs 31a∼31x and 32a∼32x are elongated down vertically and then curved inwardly at the lower portions 35 and 36. The lower portions 35 and 36 are approaching each other but remaining bottom open. Thereby the semiconductor wafers are held on the lower potions 35 and 36.

The holding grooves 35a∼35x and 36a∼36x can be easily washed and dried, because the top and the bottom of the wafer carrier 13 are opening.

Flanges 37a and 38a are outwardly protruding from the top end of the side plates 31 and 32. The flanges 37a and 38a respectively include flange side panels 37b and 38b at the outside thereof. Handles 37 and 38 are formed by the each side plate, flanges and flange side panels. The sidewalls of the wafer carrier 13 is stiffen by the handles. The wafer carrier 13 can be easily lifted up by holding the handles 37 and 38 by the hands or robots.

Figures are depicted on the upper surface of said flange 37 in order to see the number of the wafers.

Both side of the front plate 33 are outwardly protruding as protruding portions 33a and 33b which stiffen the wafer carrier 13. A handle 39 are molded on the center of upper portion of the front plate 33 for the movements or transportations of the wafer carrier 13.

The rear plate 34 has outwardly protruding stiffeners 34a and 34b along the outer surface of the side plates 31 and 32. A bar 34c is connecting both intermediate portion of the stiffeners 34a and 34b and also stiffen the wafer carrier 13.

The outer surface of the side plate 31 and 32 are corrugated so as to strengthen and lighten the wafer carrier 13 and to prevent deformation or torsion of the wafer carrier 13 while the mold.

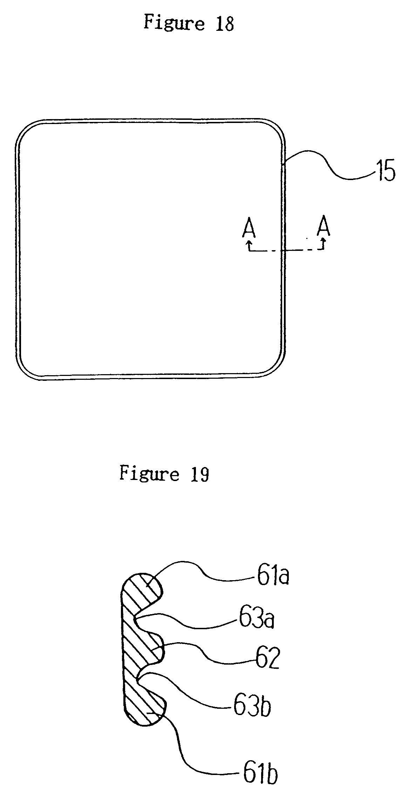

As showing figure 18, a gasket 15 are shaped a round square. the gasket 15 is inserted into the seal groove 25 of case 12. Thereby the case 12 is shut out tightly by the lid 14. The gasket 15 is preferably made of the resin which is extremely less volatile. Polyesterelastomer and etc are preferable because of its mechanical and moldable character.

As showing in Figure 19, a cross section of the gasket, the gasket 15 comprises an end protrusions 61a and 61b at the top end and the bottom end thereof, and center protrusion 62 at intermediate thereof. Thereby, constricted portions 63a and 63b are formed between each protrusions.
The center protrusion 62 is a little smaller than the end protrusions. Each protrusions are protruding toward the same side.

In this embodiment, as showing in Figure 19, right side is outer side and left side is inner side of the case 12. Therefore, each protrusions are facing to outer side, when the gasket 15 is inserted into the seal groove 25. The constricted portions 63a and 63b are bent when the lid 13 is closed, and both end protrusion 63a and 63b are pressed toward the center. The end protrusion 63a and 63b intend to be back to original position by the resiliency. The center protrusion 62 encourages such resiliency. Thereby, the case 12 is shut very tightly by the lid 14.

The container of the present invention has a seal groove on the open top of the case and the gasket is inserted into the seal groove. Whereby, the case can be airtight by the lid.

Further, the lid can be fitted on the case very firmly by the engagements of the four clips and clips recesses.

Furthermore, each clips are designed as to be able to removably install on a lid. Number of the clips can be flexible corresponding to the users' requirements. Thereby, the utility in the factories could be improved.

Therefore, the container for packing semiconductor wafer of the present invention has excellent airtightness and then can prevent from pollution by the air outside.

Each parts of the container are made of materials which the volatile matters are previously extracted from, in order to reduce the pollution by such volatile matters. The lid is made of Polycarbonate which the volatile matters are extracted. The case, the wafer carrier and the wafer support are made of Polypropylene which the volatile matters are extracted. The clips are made of Polyamide. The gasket is made of Polyesterelastomer. Polyamide and Polyesterelastomer have extremely less volatile. Accordingly, a container of the present invention has superior character to prevent pollution of the semiconductor wafer thereby.

### Industrial Applicability

This invention is relating to the container for packing semiconductor wafer which is available to be in the safekeeping and to transport safely by preventing from damage or contamination of the wafer.

## Claims

1. A container for packing semiconductor wafers of the present invention comprising;
a wafer carrier having plural holding grooves on the opposing inner walls to contain the wafers individually therein,
a wafer support which is deposited above said wafer carrier to press and hold the wafers,
a case which is box-shaped and having an open top to contain said wafer carrier and said wafer support, and
a lid which is fitted on said case to form an airtight container;
characterized in that
said wafer support includes a base plate and plural supporting spring rows which is pectinately protruding against each wafers at both edges of the base plate, and is fixed on said lid removably;
said case includes four sidewalls, a sash having plane surfaces and perpendicular corners, said sash is united with said sidewalls, handles, dented potions formed under said handles, a seal groove formed on the top of said sash for a insertion of a gasket, clip recesses respectively formed at the middle of said plane surfaces for engaging with clips, a bottom plate provided at bottom ends of said sidewalls, an arrow drawn on said bottom plate, and dents which are inwardly depressed at the bottom plate for the pile of the containers;
said lid includes four sidewalls, eaves united and horizontally protruding from said sidewalls, a sash having plane surfaces and perpendicular corner, clip recesses respectively formed at middle of said plane surfaces for engaging with clips, engaging holes to engage with top end protrusions of the clips, clips removably engaging with the lid, a ceiling provided on the top end of the sidewalls, protruding corners formed on said ceiling for the pile of the containers, and engaging grooves provided inner surface of said ceiling to removably engage with the base plate of said wafer support;
whereby semiconductor wafers are contained in said wafer carrier and held between each parts of said case and said lid.

2. A container for packing semiconductor wafers according to the claim 1 characterized in that a lid is made of Polycarbonate which the volatile matters are extracted.

3. A container for packing semiconductor wafers as defined in claim 1; wherein figures are depicted on a flange of a wafer carrier, and said figures are numbered in the order from the side for devices of the wafers therein .

4. A container for packing semiconductor wafers as defined in claim 1; wherein a handle is provided on a front plate of said wafer carrier.

5. A container for packing semiconductor wafers as defined in claim 1; wherein the outer surfaces of side plates of said wafer carrier are corrugated.

6. A container for packing semiconductor wafers as defined in claim 1; wherein a handle is provided on the top end of a side plate of said wafer carrier, and said handle is formed as a box-shaped lid.
